Europäisches Patentamt

European Patent Office

Office européen des brevets

(19)

(11) **EP 1 290 808 B1**

(12) **EUROPÄISCHE PATENTSCHRIFT**

| | |
|---|---|
| (45) Veröffentlichungstag und Bekanntmachung des Hinweises auf die Patenterteilung: **03.11.2004 Patentblatt 2004/45** | (51) Int Cl.$^7$: **H04B 1/713**, H04L 1/00, H03M 13/23, H03M 13/29 |
| (21) Anmeldenummer: **01960262.2** | (86) Internationale Anmeldenummer: **PCT/EP2001/006276** |
| (22) Anmeldetag: **01.06.2001** | (87) Internationale Veröffentlichungsnummer: **WO 2001/097401 (20.12.2001 Gazette 2001/51)** |

(54) **SYSTEM ZUR DATENÜBERTRAGUNG NACH DEM FREQUENZSPRUNGVERFAHREN**

SYSTEM FOR DATA TRANSMISSION ACCORDING TO THE FREQUENCY HOPPING METHOD

SYSTEME DE TRANSMISSION DE DONNEES BASE SUR LE PROCEDE DU SAUT DE FREQUENCES

(84) Benannte Vertragsstaaten:
**DE FR GB IT**

(30) Priorität: **14.06.2000 DE 10029308**
**26.03.2001 DE 10114834**

(43) Veröffentlichungstag der Anmeldung:
**12.03.2003 Patentblatt 2003/11**

(73) Patentinhaber: **Rohde & Schwarz GmbH & Co. KG**
**81671 München (DE)**

(72) Erfinder:
• **BOTT, Rainer**
**82346 Andechs (DE)**
• **KOROBKOV, Dimitri**
**60322 Frankfurt (DE)**

(74) Vertreter: **Körfer, Thomas, Dipl.-Phys. et al**
**Mitscherlich & Partner,**
**Patent- und Rechtsanwälte,**
**Sonnenstrasse 33**
**80331 München (DE)**

(56) Entgegenhaltungen:
**US-A- 5 519 718**

• **STEFAN HÖST: "On Woven Convolutional Codes " [Online] 24. September 1999 (1999-09-24) , KFS AB , LUND, SWEDEN XP002181075 ISBN: 91-7167-016-5 Gefunden im Internet: <URL: http://www.it.lth.se/~stefanh/Thesis/Thesis.pdf> [gefunden am 2001-10-24] in der Anmeldung erwähnt Seite 83, Zeile 1 -Seite 130, Zeile 2; Abbildungen 5.1-6.12**
• **ZYABLOV V ET AL: "On the error exponent for woven convolutional codes with outer warp" IEEE TRANSACTIONS ON INFORMATION THEORY, JULY 1999, IEEE, USA, Bd. 45, Nr. 5, Seiten 1649-1653, XP002181074 ISSN: 0018-9448**

EP 1 290 808 B1

**Beschreibung**

Die Erfindung betrifft ein System laut Oberbegriff der Ansprüche 1,4,7 und 10.

Bei der Übertragung von digitalen Daten nach dem Frequenzsprungverfahren (frequency hopping), bei dem die Daten in sprunghaft wechselnden Sendefrequenz-Abschnitten (hops) übertragen werden, werden die Signale meist durch Rauschen oder andere Einflüsse wie Fading, Dopplershift und dergleichen beeinträchtigt. Ein Fading-Einbruch oder eine Störung führen dabei zur Unterdrückung einzelner oder sogar mehrerer Frequenzabschnitte, so daß die gesamte Information (Nutzdaten und FEC-Redundanz) verloren geht. Es ist auch schon bekannt, bei solchen Frequenzsprungverfahren die Datensymbole in den einzelnen Sendefrequenzabschnitten nach einem aus einem äußeren und inneren Code bestehenden sogenannten verketteten Code zu codieren.

Diese verketteten Codes haben den Nachteil, daß nach der fehlerhaften Decodierung des inneren Codes ein Fehlerburst (aber kein unabhängiger Fehler) entsteht. Infolgedessen erzeugt der Decoder des äußeren verketteten Codes mehrere Fehler, da der äußere Code in der Regel schlechte Korrektureigenschaften hinsichtlich solcher Fehlerbursts aufweist.

Die US-A-5 519 718 beschreibt ein System zur Datenübertragung nach dem Frequenzsprungverfahren, bei dem die digitalen Daten in sprunghaft wechselnden Sendefrequenz-Abschnitten übertragen werden, wobei die Daten in den aufeinanderfolgenden Frequenzabschnitten codiert werden.

Aus STEFAN HÖST: 'On Woven Convolutional Codes' [Online] 24, September 1999 (1999-09-24), KFS AB, LUND, SWEDEN, ISBN: 91-7167-016-5, ist es als solches bekannt, einen Woven-code zu benutzen, der aus der Verkettung von äußeren und inneren Faltungscodes besteht.

Es ist daher Aufgabe der Erfindung, ein System zur Datenübertragung nach dem Frequenzsprungverfahren aufzuzeigen, bei dem diese Nachteile so gut wie möglich vermieden sind und das eine möglichst sichere Datenübertragung auch bei starken Verzerrungen durch den Übertragungskanal gewährleistet,

Diese Aufgabe wird ausgehend von einem System laut Oberbegriff der Ansprüche 1, 4, 7 und 10 durch deren kennzeichnende Merkmale gelöst. Vorteilhafte Weiterbildungen ergeben sich aus den Unteransprüchen.

Die Verwendung sogenannter Woven Codes, wie sie beispielsweise im Detail beschrieben sind in Host, S. Johannesson, R. und Zyablov, V.: "A First encounter with binary woven convolutional codes", In. Proc. International Symposium on Communication Theory and Application, Lake District, UK July 1997 bzw. Host, S. On Woven Convolutional Codes. Ph.D. Thesis, Lund University, 1999. ISBN 91-7167-016-5, http://www.it.lth.se/stefanh/thesis/, gewährleistet auch bei starken Verzerrungen durch den Kanal wie Fadingeinbrüchen, daß die verloren gegangene Information in den gestörten Frequenzabschnitten durch die verwendete Codierung wiedergewonnen werden kann. Bei Woven-Codes werden die erwähnten Decodier-Fehler, hervorgerufen durch Fehlerbursts, weitestgehend vermieden, da die durch den Decoder erzeugten Fehlerbursts zwischen den verschiedenen inneren bzw. äußeren Codes unabhängig voneinander verteilt werden, was schließlich zu unabhängigen Fehlern im jeweils anderen Code (äußerer bzw. innerer Code) führt, wie dies nachfolgend anhand von Beispielen näher erläutert wird. Als besonders vorteilhaft hat es sich erwiesen, die Codierung innerhalb eines Sendefrequenz-Abschnitts jeweils im Frequenzabschnitt zu terminieren, d.h. die Codierung beginnt mit dem Anfang des Frequenzabschnittes und endet mit diesem. Dadurch wird vermieden, daß ein eventuell gelöschter Frequenzabschnitt die Information am Anfang bzw. am Ende des vorhergehenden bzw. nächstfolgenden Frequenzabschnittes verfälscht, die Codierung in einem Frequenzabschnitt also unabhängig von den anderen Frequenzabschnitten funktioniert. Das erfindungsgemäße System kann bei allen möglichen Übertragungskanälen angewendet werden, beispielsweise bei einem sogenannten AWGN-Kanal (Übertragungskanal mit additivem weißen Gauß'schen Rauschen) oder auch bei Rayleigh-Kanälen. Die Verwendung von binären Faltungscodes ermöglicht es, für die Decodierung des äußeren Codes sogenannte Soft-Decodierungen einzusetzen bzw. sogenannte iterative Decodierungen, wie sie beispielsweise beschrieben sind in Johannesson R., Zigangirov, K... "Fundamentals of Convolutional Coding", IEEE Press, 1999, ISBN 0-7803-3483-3.

Beim System laut Anspruch 1 werden die gesamten Daten eines Frequenzabschnitts (Hops) über auf einem frequenzmäßig zusammenhängenden Frequenzabschnitt übertragen, daher können Störungen wie Fading-Einbrüche mit flat fading oder Aussendungen von anderen Sendern (Kollisionen bei CSMA) den gesamten Frequenzabschnitt löschen.

Letztere Nachteile können zumindest teilweise beseitigt werden durch die Weiterbildung nach den Ansprüchen 29 und folgende.

Die Erfindung wird im Folgenden anhand schematischer Zeichnungen an Ausführungsbeispielen näher erläutert.

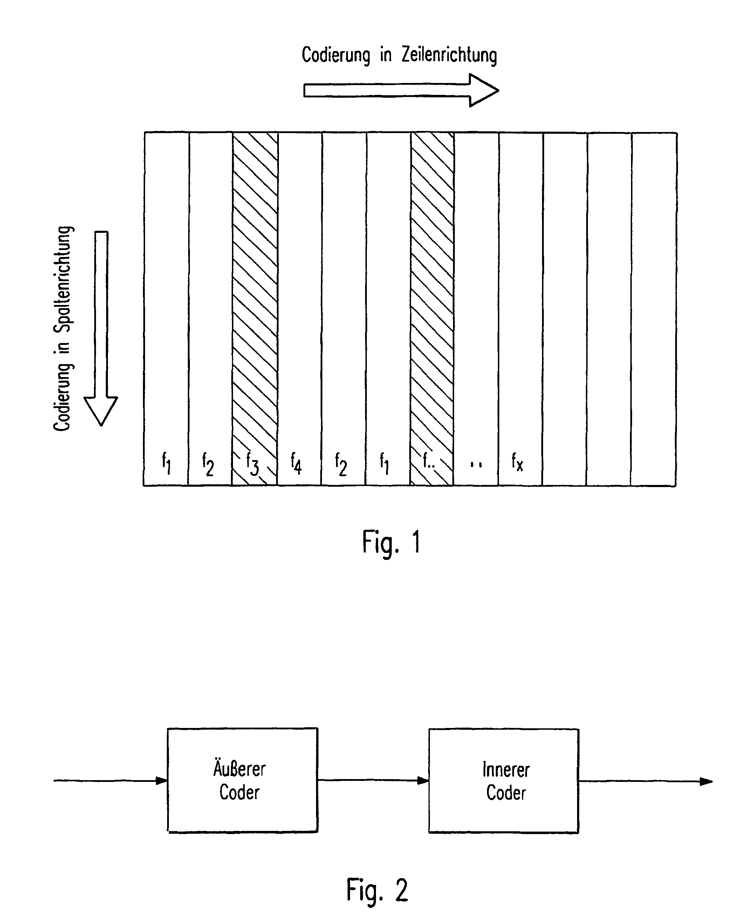

Figur 1 zeigt schematisch die Übertragung von digitalen Daten nach dem Frequenzsprungverfahren. Die Daten werden dabei in sprunghaft wechselnden zeitlich aufeinanderfolgenden Sendefrequenz-Abschnitten f1 bis $f_x$, die sich in beliebiger Reihenfolge wiederholen können, vom Sender zum Empfänger übertragen. Durch Fading-Einbrüche oder andere Verzerrungen können einige oder mehrere dieser Frequenzabschnitte unterdrückt werden, wie dies in Figur 1 für einige Abschnitte gestrichelt dargestellt ist. Die zu übertragenden Daten werden nach einem bekannten Woven Code, wie er in der eingangs beschriebenen Literatur von Host näher beschrieben ist, nach einem äußeren und einem damit verketteten inneren Faltungscode codiert. Die Datensymbole, die in einem Frequenzabschnitt übertragen werden, lassen sich mathematisch wie eine Spalte einer Matrix. interpretieren, so daß die Übertragung insgesamt als Codierung in Richtung Matrixspalten und Codierung in Richtung Matrixzeilen einer semi-unendlichen Matrix interpretiert werden kann.

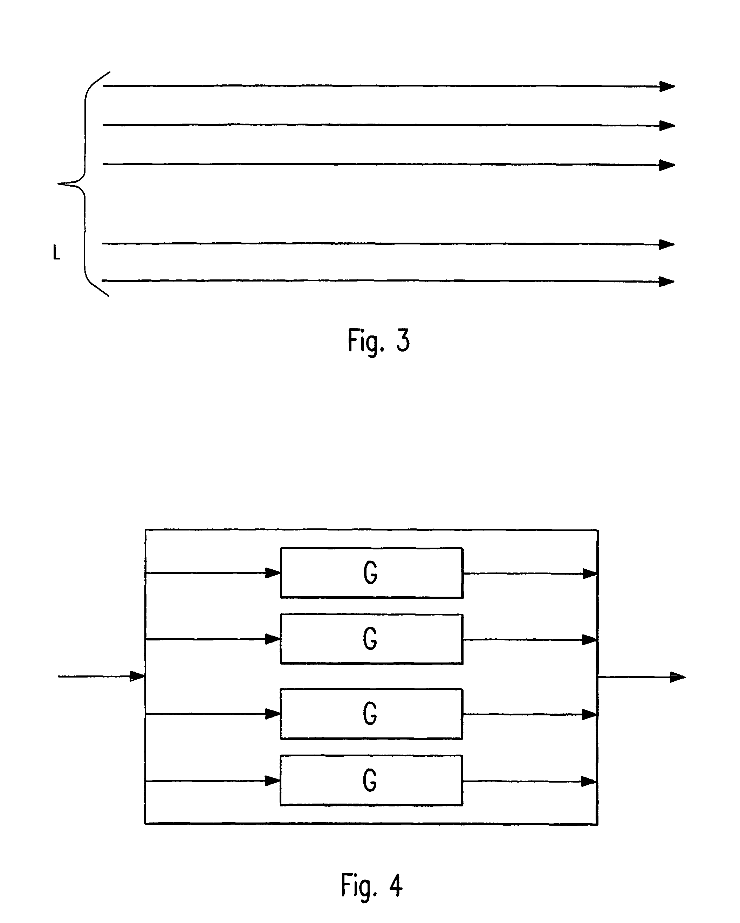

Figur 2 zeigt schematisch einen bekannten Woven Code bestehend aus der Verkettung eines äußeren und inneren Faltungscodes ohne Buffer. Bei einem solchen Woven Code ist es für die Korrektur eines Fehlerbursts der Länge L ausreichend, wenn ein Interleaving der L-Codes, die in der Lage sind, einen Fehler zu korrigieren, benutzt wird. Wenn in diesem Fall jeder einzelne Codes in der Lage ist, t-Fehler zu korrigieren, dann wird die daraus resultierende Konstruktion t Fehlerbursts korrigieren. Dies ist in Figur 3 für verkettete Codes schematisch dargestellt. Der Coder einer solchen Konstruktion umfaßt eine parallele Kombination von Codes, wie dies in Figur 4 dargestellt ist.

Allgemein kann ein solcher verketteter Codes mit seiner Generatormatrix durch folgende Formel dargestellt werden:

$$G^c = G \otimes I_L$$

Das entspricht dem Kroneckerschen Produkt einer Generatormatrix des Faltungscodes G mit einer Identitätsmatrix I der Größe L.

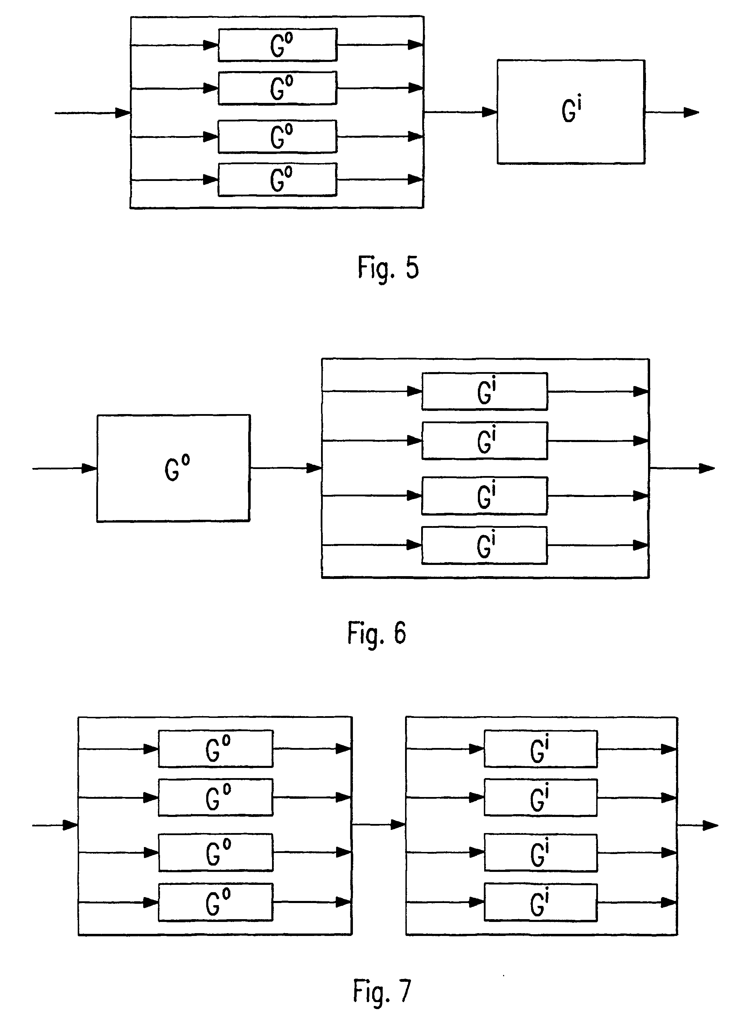

Figur 5 zeigt das Prinzipschema eines sogenannten Woven Codes mit outer warp, wie er durch die verkettete Vereinigung von zwei Faltungscodes nach Figur 2 entsteht und zwar durch Ersatz des äußeren Codes nach Figur 2 durch die Codeskonstruktion nach Figur 4. Die Generatormatrix dieses Codes nach Figur 5 folgt der Formel

$$G^{ow} = (G^o \otimes I_{Lo}) \cdot G^i,$$

dabei ist $G^{ow}$ die Generatormatrix des Woven Codes mit outer warp, $G^o$ und $G^i$ entsprechen den Generatormatrizen des äußeren und inneren Codes und $I_{Lo}$ ist eine Identitätsmatrix der Ordnung Lo.

Daraus ergibt sich, daß während der Decodierung die durch den Decoder des inneren Codes erzeugten Fehlerbursts zwischen den verschiedenen äußeren Codes gleichmäßig verteilt werden. Dies führt zu unabhängigen Fehlern im äußeren Code.

Wenn in der verketteten Vereinigung der zwei Faltungscodes der innere Code durch die beschriebene Konstruktion nach Figur 4 ersetzt wird, ergibt sich der sogenannte Woven Code mit inner warp gemäß Figur 6. Die Generatormatrix

$$G^{iw} = G^o \cdot (G^i \otimes I_{Li})$$

dabei ist $G^{iw}$ die Generatormatrix des Woven Codes mit outer warp. $G^o$ und $G^i$ entsprechen den Generatormatrizen des äußeren und inneren Codes und $I_{Li}$ ist die Identitätsmatrix der Ordnung Li.

Auch hier werden während der Decodierung die durch den Decoder erzeugten Fehlerbursts zwischen den verschiedenen inneren Codes unabhängig verteilt. Dies führt wiederum zu unabhängigen Fehlern im äußeren Code.

Wenn in der verketteten Vereinigung der zwei Faltungscodes sowohl der innere als auch der äußere Code durch die beschriebene Konstruktion nach Figur 4 ersetzt wird, ergibt sich der sogenannte Woven Code mit double warp (twill) nach Figur 7. Die Generatormatrix dieses Codes folgt der Formel

$$G^{dw} = (G^o \otimes I_{Lo}) \cdot (G^i \otimes I_{Li}),$$

dabei ist $G^{dw}$ die Generatormatrix des Woven Code mit double warp, $G^o$ und $G^i$ entsprechen der Generatormatrix des äußeren und inneren Codes, $I_{Lo}$ ist die Identitätsmatrix der Ordnung Lo und $I_{Li}$ ist die Identitätsmatrix der Ordnung Li.

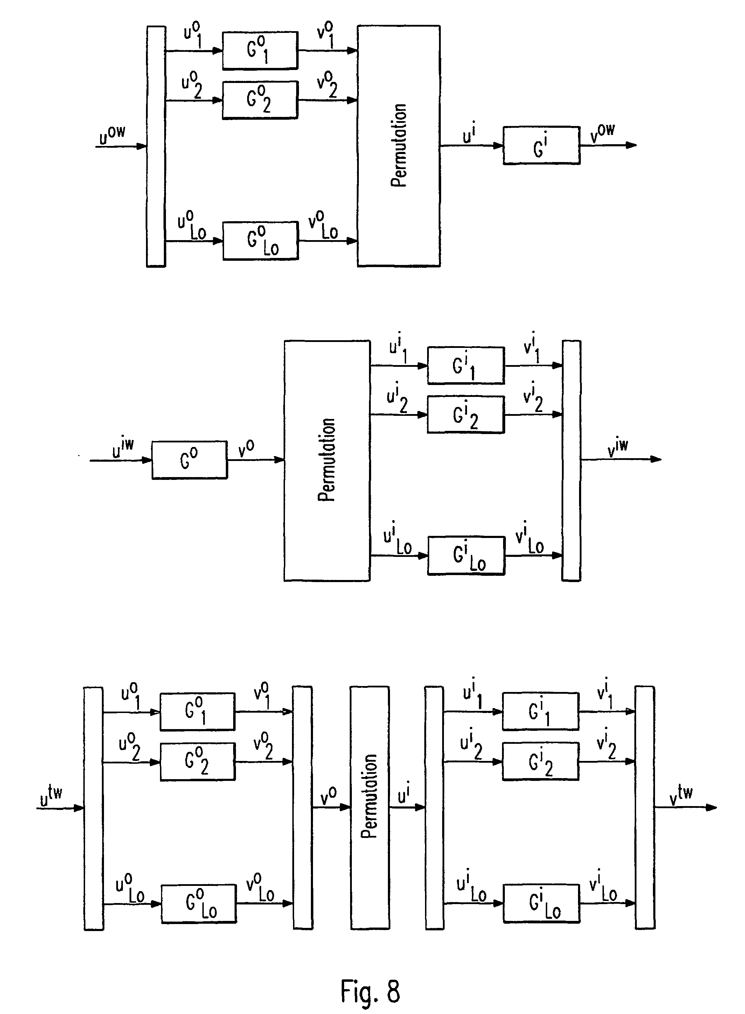

In jedem der genannten Codes der Woven Codes kann eine Permutation zwischen den Codern des inneren und äußeren Codes implementiert werden. Dies erlaubt besonders in AWGN-Kanälen die Verbesserung der Korrektureigenschaften. Das entsprechende Schema der Coder für outer warp, inner warp und double warp ist in Figur 8 dargestellt.

Nachfolgend wird für die aufgezeigten verschiedenen Arten eines Woven Codes die Aufteilung der Redundanz der inneren und äußeren Codes zwischen den Zeilen und Spalten bzw. zwischen den aufeinanderfolgenden Frequenzabschnitten und innerhalb der einzelnen Frequenzabschnitte erläutert. Als Beispiel hierfür dient ein Woven Codes mit der Codesrate R = 1/8. Dabei wird angenommen, daß in allen Fällen als äußere und innere Codes systematische Faltungscodes mit rekursiver Codierung benutzt werden.

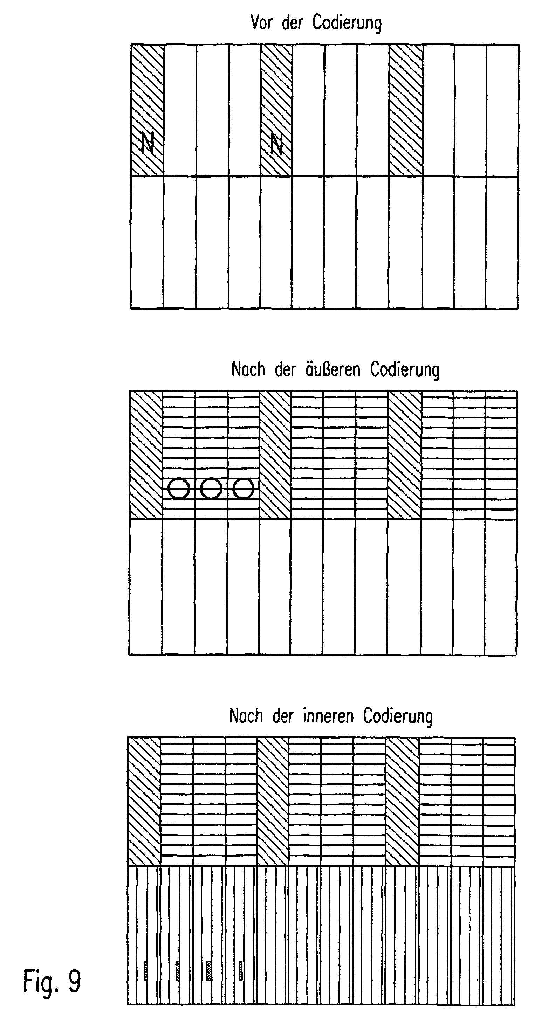

Figur 9 zeigt wieder den Woven Codes mit outer warp. In den Zeichnungen sind die Nutzinformationen N schräg schraffiert, die Prüfsymbole des äußeren Codes O horizontal schraffiert und die Prüfsymbole des inneren Codes I jeweils vertikal schraffiert dargestellt.

Aus dem eingangs erwähnten Schema des Woven Codes erfolgt zunächst die Codierung mit den Prüfinformationen des äußeren Codes auf den zwischen den Nutzinformationen N gesendeten Frequenzabschnitten und zwar mit einem Faltungscodes mit der Rate $R^o$ = 1/4. Anschließend werden sämtliche Frequenzabschnitte (hops) unabhängig voneinander mit einem gegebenenfalls terminierten Faltungscode mit der Rate $R^i$ = 1/2 codiert.

Vor der Codierung mit dem inneren Code können die Symbole in jedem Hop auf verschiedene Weise einer Permutation unterzogen werden. Die Periode der Permutation ist T hops, d.h. der i-te hop und der i+T-hop werden ein und derselben Permutation unterzogen. Die Permutation wird unter anderem in "Bronstein-Semendjajew Taschenbuch der Mathematik" beschrieben.

Durch diese Art der Codierung wird ein Woven Codes mit outer warp in modifizierter Form erzeugt, bei dem abweichend vom klassischen Fall der innere Codes in jedem hop terminiert ist.

Gleichzeitig kann eine an sich bekannte Punktierung des äußeren Codes durchgeführt werden, wie dies z.B. beschrieben ist bei "J. Hagenauer, "Rate.-Compatible Punctured Convolutional Codes (RCPC Codes) and their Applications", IEEE Transactions on Communications, Vol. 36, No. 4, April 1988, Seite 389ff.. Durch eine solche an sich bekannte Punktierung kann die Coderate entsprechend erhöht werden und zwar auf R = (1/6 1/4 ).

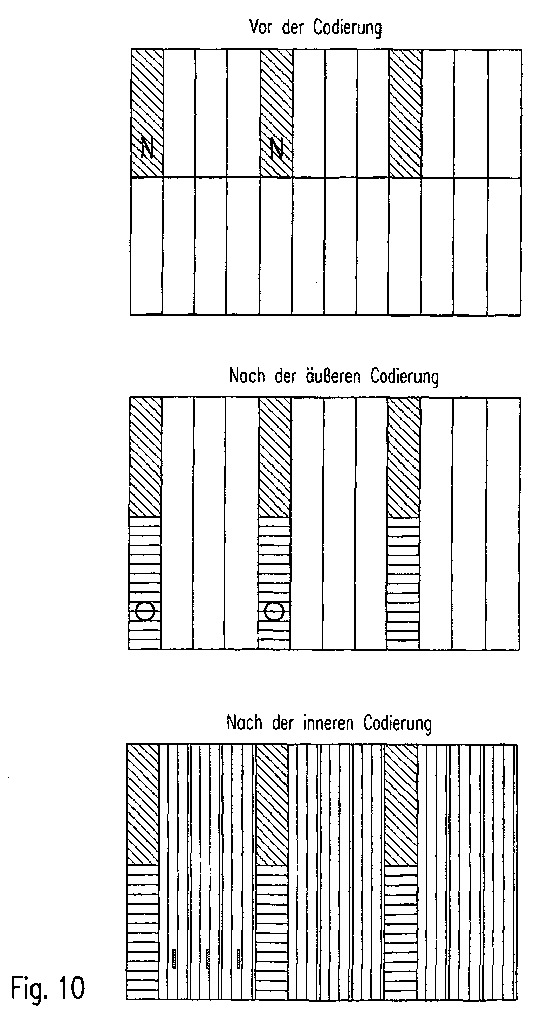

Das System des Woven Codes mit inner warp zeigt Figur 10. Hier werden zuerst unabhängig voneinander die aufeinanderfolgenden Frequenzabschnitte mit einem Faltungscodes mit der Rate $R^o$ = 1/2 codiert. Danach können unabhängig voneinander alle Hops mit einem gegebenenfalls terminierten Faltungscodes mit der Rate $R^i$ = 1/4 codiert werden.

Vor der Codierung mit dem inneren Codes können die Symbole in jedem Hop auf verschiedene Weise wieder einer Permutation unterzogen werden, die Periode der Permutation ist wieder T Hops.

Auch hierdurch wird wieder ein modifizierter Woven Codes mit inner warp erhalten, bei dem der äußere Codes in jedem Frequenzabschnitt terminiert sein kann. Der resultierende Codes wird ungeachtet der Terminierung des äußeren Codes zu einem Faltungscode mit der Rate

$$R^{iw} = R^\circ \times R^i = 1/8.$$

Wie beim outer warp kann durch eine Punktierung die Codesrate erhöht werden.

Die Unterbringung der Prüfsymbole in den Frequenzabschnitten zusammen mit den Informationssymbolen kann in manchen Fällen nachteilig sein, beispielsweise wenn durch Fading Frequenzabschnitte ganz oder teilweise unterdrückt und gelöscht werden.

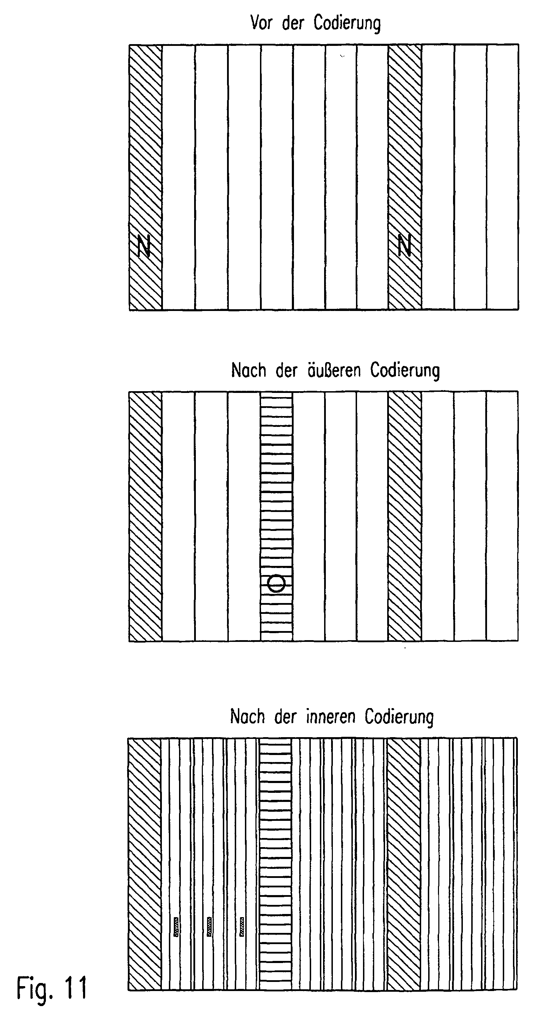

Diesen Nachteil vermeidet der in Figur 11 dargestellte Woven Codes mit doppel warp, bei dem die Prüfinformationen des äußeren Codes O und die Prüfinformationen des inneren Codes I jeweils in getrennten Hops zwischen den Nutzinformationen N übertragen werden.

Im untersuchten Fall werden die Informationssymbole periodisch mit der Periode 1/$R^{dw}$ in die Hops geschrieben, wobei $R^{dw}$ die Rate dieser Konstruktion darstellt.

Wie aus dem Schema des Coders folgt, werden zuerst unabhängig voneinander die Hops mit einem Faltungscode mit der Rate $R^o$= 1/2 codiert.

Das Resultat einer solchen Codierung (Prüfsymbole des äußeren Codes) wird periodisch mit der Priode 1/$R^{dw}$ in die entsprechenden Hops geschrieben.

Danach werden unabhängig voneinander alle Hops mit mehreren Faltungscodes mit der Rate $R^i$ = 1/4 codiert.

Vor der Codierung mit dem inneren Code können die Symbole in jedem Hops auf verschiedene Weise einer Permutation unterzogen werden. Die Periode der Permutation ist T Hops.

Als Resultat einer solchen Codierung wird ein Woven Code mit double warp erhalten.

Der daraus resultierende Code, ungeachtet einer Terminierung des äußeren Codes, wird zu einem Faltungscode mit der Rate

$$R^{dw} = R^o \cdot R^i = 1/8$$

Wie beim outer warp kann durch eine Punktierung die Coderate erhöht werden.

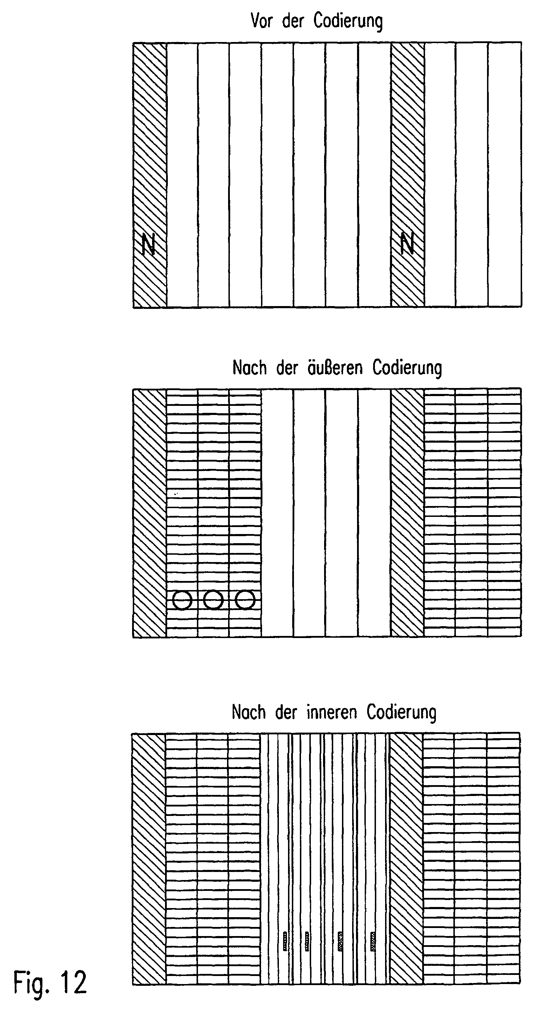

Im Folgenden wird die Konstruktion des Woven Turbo Codes erreicht. Die allgemeine Verteilung der Informations- und Prüfsymbole zwischen den Hops und in den Hops ist in Figur 12 dargestellt.

Die Informationssymbole werden periodisch mit der Periode 1/$R^{wt}$ in die Hops geschrieben, wobei $R^{wt}$ die Rate dieser Konstruktion darstellt. Wie aus dem Schema des Coders folgt, werden im Beispiel zuerst unabhängig voneinander die Hops mit einem Faltungscode mit der Rate $R^o$ = 1/4 codiert.

Das Resultat der Codierung (Prüfsymbole des äußeren Codes) werden periodisch mit der Periode 1/$R^{wt}$ in die entsprechenden Hops geschrieben. Danach werden alle Hops (nur die Informationssymbole) unabhängig voneinander mit mehreren Faltungscodes mit der Rate $R^i$ = 1/5 codiert.

Vor der Codierung mit den inneren Codes können die Symbole in jedem Hops auf verschiedene Weise einer Permutation unterzogen werden. Die Periode der Permutation ist T Hops.

Als Resultat einer solchen Codierung erhalten wir einen Woven Turbo Code. Alle Prüfsymbole beider Codes werden zwischen den verschiedenen Spalten verteilt. Zusätzlich hat jeder der einzelnen Codes eine geringere Rate. Dies ist vorteilhaft bei der Übertragung in schlechten Kanälen.

Der daraus resultierende Code wird zu einem Faltungscode mit der Rate

$$R^{wt} = \frac{R^o \cdot R^i}{R^o + R^i - R^o \cdot R^i} = 1/8$$

Durch eine Punktierung sowohl bzw. wahlweise des äußeren und inneren Codes mit einem Code mit den Raten

$$R = \left\{ \frac{1}{7}, \frac{1}{6}, \frac{1}{5}, \frac{1}{4}, \frac{1}{3} \right\}$$

erhalten

Neben der periodischen und systematischen Aufteilung von Informations- und Prüfinformationen kann es auch vorteilhaft sein, abhängig vom Kanal, über den die Übertragung stattfinden soll, Hops mit Informations- und/oder Prüfinformationen zeitlich zu bündeln.

Für die Decodierung wird ein iterativer Turbo Decoder verwendet. Solche Decoder sind bekannt, z.B. in Johannesson, R.; Zigangirov, K.."Fundamentals of Convolutional Coding", IEEE Press, 1999, ISBN 0-7803-3483-3 beschrieben. Bei der Decodierung werden die Strukturen der Code-Schemata bzw. Parallellität der Codes (outer warp, inner warp, double warp und woven turbo) sowie der Verwendung der Permuter gemäß Figur 8 berücksichtigt.

Vorteilhaft werden die äußeren und inneren Codes mit Hilfe des A-Posteriori-Probability Algorithmus (APP) decodiert. Dieser Algorithmus ist ebenfalls bekannt und in Johannesson beschrieben. Da der Empfänger die verwendete Code-Konstruktion kennt, kann er das Wissen um die Terminierung der Codes zur Reduktion des Aufwandes im Decoder verwenden.

Wird der APP in einer sliding window Version benutzt, so kann die Verzögerung bei der Decodierung minimiert werden und an die für die Übertragung maximal zulässige Verzögerung angepaßt werden.

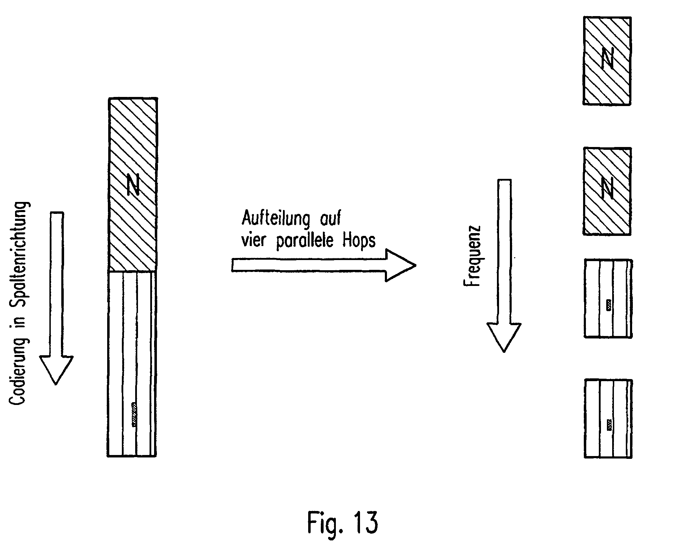

Fig. 13 zeigt die Verteilung der Daten eines Frequenzabschnitts (Hops) auf mehrere parallele Frequenzabschnitte, die jeweils mit unterschiedlichen Frequenzen ausgesendet werden.

Fig. 13 zeigt dies bei einem woven code mit outer warp. Die Nutzinformationen N werden auf zwei Frequenzabschnitten (Hops) und die Prüfsymbole des inneren Codes der Coderate ½ auf ebenfalls zwei Frequenzabschnitten parallel gesendet. Bei nachfolgenden Betrachtungen wird vorausgesetzt, daß Störungen und Fading-Einbrüche gleich verteilt über den Bereich, in dem das Übertragungssystem arbeitet, sowie statistisch unabhängig voneinander sind. Diese Annahmen sind bei genügend großen Frequenzbereichen in der Regel gegeben.

Die Anzahl der parallelen Frequenzabschnitte ist im Prinzip frei wählbar. Aufgrund des Frequenzsprungverfahrens muß jedoch für jeden dieser parallelen Frequenzabschnitte in der Regel eine getrennte Trä-ger- und Symboltaktsynchronisation durchgeführt wer-den. Für diese Synchronisation werden Zusatzinformationen benötigt, welche die eigentliche Übertragungsrate reduzieren. Bei zu vielen parallelen Frequenzabschnitten sinkt dem gemäß diese Übertragungsrate stark ab.

Beim Verfahren mit outer warp wird wieder nur ein innerer Code verwendet. Bei der Übertragung auf mehreren parallelen Frequenzabschnitten werden alle Nutzinformationen und die Prüfsymbole der äußeren Codes, die auf die parallelen Frequenzabschnitte verteilt sind, mit diesem inneren Code geschützt. Wird nun einer der Frequenzabschnitte gestört, so kann, wenn der innere Code die entsprechende Fehlerkorrekturmöglichkeit besitzt, die Nutzinformation, die in den parallel ausgesendeten Frequenzabschnitten enthalten ist, wiedergewonnen werden. Durch diese zusätzliche Korrekturmöglichkeit des inneren Codes werden entsprechend weniger Fehler bei der inneren Decodierung erzeugt, so daß die äußeren Codes insgesamt weniger Fehler korrigieren müssen und die Leistungsfähigkeit der gesamten Anordnung erhöht wird. Die Konstruktion mit outer warp nach der inneren Codierung entspricht wieder Fig. 9. Die in Spaltenrichtung angeordneten Nutzdaten N bzw. Prüfsymbole der äußeren Codes werden zusammen mit dem Prüfsymbolen des inneren Codes auf die parallel ausgesendeten Frequenzabschnitte verteilt.

Beim Verfahren mit innerer warp schützen die inneren Codes die auf den parallelen Frequenzabschnitten ausgesendeten Nutzinformationen sowie die Prüfsymbole des äußeren Codes. Wenn nun einer der parallelen Frequenzabschnitte gestört wird, ist nur ein Teil der inneren Codes betroffen.

Demgemäß muß auch nur der betroffene Teil der inneren Codes die zusätzlichen Fehler korrigieren. Dies hilft dem äußeren Code bei der Decodierung. Die Konstruktion mit inner warp ist in Fig. 10 dargestellt. Die in Spaltenrichtung angeordneten Nutzdaten und Prüfsymbole des äußeren Codes bzw. die Prüfsymbole der inneren Codes werden auf die parallel ausgesendeten Frequenzabschnitte verteilt.

Beim Verfahren mit double warp werden Nutzinformationen sowie Prüfsymbole in unterschiedlichen Hops übertragen. Aufgrund der oben angeführten statistischen Gleichverteilung der Fading-Einbrüche und Störung wird nur ein Teil der äußeren Codes gestörte Symbole korrigieren müssen. Die Konstruktion mit double warp ist in Fig. 11 dargestellt. Die in Spaltenrichtung angeordneten Nutzdaten bzw. Prüfsymbole der äußeren und inneren Codes werden auf die parallel ausgesendeten Hops verteilt.

Bei der woven turbo Codierung werden wie beim double warp die Nutzinformationen, die Prüfsymbole des äußeren sowie der inneren Codes auf paralle-len Frequenzabschnitten übertragen. Diese Konstrukti-on entspricht Fig. 12. Die in Spaltenrichtung angeordneten Nutzdaten bzw. Prüfsymbole des äußeren und der inneren Codes werden auf die parallel ausgesendeten Frequenzabschnitte verteilt.

Dieses Prinzip bietet bei allen Codekonstruktionen Vorteile gegenüber der Übertragung auf einem frequenzmäßig zusammenhängenden Frequenzabschnitt. Aufgrund der Codekonstruktion des inner und outer warp ist es hier jedoch besonders vorteilhaft einsetzbar.

Die einzelnen parallelen Frequenzabschnitte (Hops) können im Frequenzbereich mit konstant bleibenden Frequenzabstand, gegebenenfalls auch äquidistant, gewählt sein. Wenn mehrere Sender mit dem selben Verfahren im selben Frequenzbereich senden und das Frequenzsprungmuster nicht orthogonal ist, können hierbei jedoch sämtliche parallelen Frequenzabschnitte gestört werden. Es ist daher vorteilhaft, einen speziellen Algorithmus einzusetzen, der die Verteilung der parallelen Frequenzabschnitte im Frequenzbereich so vornimmt, daß solche Störungen vermieden werden. In der Regel wird dieser Algorithmus zeitlich abhängige Anordnungen erzeugen.

Die Aufteilung der Nutz- und Prüfsymbole auf die parallelen Frequenzabschnitte ist im Prinzip beliebig wählbar. Die Zuordnung kann gegebenenfalls auch zeitlich permutiert werden. So kann zum Beispiel bei einer Anordnung mit outer warp die Aufteilung der Nutzinformation und der Prüfsymbole des inneren Codes auf die einzelnen parallel ausgesendeten Frequenzabschnitte zeitlich variieren. Eine solche Permutation kann ebenfalls nach einem speziellen Algorithmus erfolgen. Es ist auch denkbar, die zu übertragenden Daten nicht auf die parallelen Frequenzabschnitte aufzuteilen sondern auf jedem der parallelen Frequenzabschnitte sämtliche Daten vollständig und gleichzeitig zu übertragen.

Anstelle der Aufteilung der je Frequenzabschnitt zu übertragenden Daten auf mehrere parallel gesendete Frequenzabschnitte ist auch ein vereinfachtes System möglich, bei dem die gesamten Daten eines Frequenzabschnittes jeweils auf mehreren parallelen Frequenzabschnitten, die mit unterschiedlicher Frequenz gesendet werden, übertragen werden. In diesem Fall könnten dann im Empfänger bekannte Verfahren benutzt werden, um die so im Frequenz Diversity übertragenen Daten wieder zu kombinieren. So könnten beispielsweise alle parallelen Frequenzabschnitte (Hops) vollständig und parallel dekodiert werden und anschließend könnte eine Auswahl nach dem Mehrheitsprinzip vorgenommen werden. Eine andere Möglichkeit ist, die einzelnen Frequenzabschnitte nach dem Prinzip des Maximum Racio Combining zusammenzufassen und anschließend in einem einzigen Decoder zu decodieren.

### Patentansprüche

1. System zur Datenübertragung nach dem Frequenzsprungverfahren, bei dem die digitalen Daten in sprunghaft wechselnden Sendefrequenz-Abschnitten übertragen werden,
   wobei die Daten in den aufeinanderfolgenden Frequenzabschnitten nach einem Woven Code codiert werden, der aus der Verkettung eines äußeren und eines inneren Faltungscodes besteht,
   **dadurch gekennzeichnet,**
   **daß** nach dem Woven Code mit Outer Warp codiert wird, wobei die Nutzinformationen in einem der Frequenzabschnitte, die Prüfinformationen des äußeren Codes auf anderen der Frequenzabschnitte und die Prüfinformationen des inneren Codes zusammen mit den Nutzinformationen und den Prüfinformationen des äußeren Codes auf sämtlichen Frequenzabschnitten übertragen werden.

2. System nach Anspruch 1,
   **dadurch gekennzeichnet,**
   **daß** der innere Code terminiert ist.

3. System nach Anspruch 2,
   **dadurch gekennzeichnet,**
   **daß** der äußere Code eine größere Redundanz aufweist.

4. System zur Datenübertragung nach dem Frequenzsprungverfahren, bei dem die digitalen Daten in sprunghaft wechselnden Sendefrequenz-Abschnitten übertragen werden,
   wobei die Daten in den aufeinanderfolgenden Frequenzabschnitten nach einem Woven Code codiert werden, der aus der Verkettung eines äußeren und eines inneren Faltungscodes besteht,
   **dadurch gekennzeichnet,**
   **daß** nach dem Woven Code mit Inner Warp codiert wird, wobei die Nutzinformationen und Prüfinformationen des äußeren Codes zusammen in einem der Frequenzabschnitte übertragen werden und die Prüfinformationen des inneren Codes in jeweils anderen Frequenzabschnitten übertragen werden.

5. System nach Anspruch 4,
   **dadurch gekennzeichnet,**
   **daß** der äußere Code terminiert ist.

6. System nach Anspruch 4 oder 5,
   **dadurch gekennzeichnet,**
   **daß** der innere Code eine größere Redundanz besitzt.

7. System zur Datenübertragung nach dem Frequenzsprungverfahren, bei dem die digitalen Daten in sprunghaft wechselnden Sendefrequenz-Abschnitten übertragen werden,
   wobei die Daten in den aufeinanderfolgenden Frequenzabschnitten nach einem Woven Code codiert werden, der aus der Verkettung eines äußeren und eines inneren Faltungscodes besteht,
   **dadurch gekennzeichnet,**
   **daß** nach dem Woven Code mit Double Warp codiert wird und die Nutzinformationen, Prüfinformationen des äußeren Codes und die Prüfinformationen des inneren Codes jeweils in unterschiedlichen Frequenzabschnitten übertragen werden.

8. System nach Anspruch 7,
   **dadurch gekennzeichnet,**
   **daß** der äußere Code terminiert ist.

9. System nach Anspruch 7 oder 8,
   **dadurch gekennzeichnet,**
   **daß** der innere Code eine größere Redundanz besitzt.

10. System zur Datenübertragung nach dem Frequenzsprungverfahren, bei dem die digitalen Daten in sprunghaft wechselnden Sendefrequenz-Abschnitten übertragen werden,
    wobei die Daten in den aufeinanderfolgenden Frequenzabschnitten nach einem Woven Code codiert werden, der aus der Verkettung eines äußeren und eines inneren Faltungscodes besteht,
    **dadurch gekennzeichnet,**
    **daß** nach dem Wovon Turbocode codiert wird, wobei für den inneren und äußeren Faltungscode jeweils etwa die gleiche Coderate verwendet wird und die Nutzinformationen sowie die Prüfinformationen des äußeren und inneren Codes jeweils in getrennten Frequenzabschnitten übertragen werden.

11. System nach Anspruch 10,
    **dadurch gekennzeichnet,**
    **daß** sowohl der äußere als auch der innere Code punktiert wird.

12. System nach einem der Ansprüche 1 bis 11,
    **dadurch gekennzeichnet,**
    **daß** der innere und/oder äußere Code terminiert ist.

13. System nach einem der Ansprüche 1 bis 10,
    **dadurch gekennzeichnet,**
    **daß** der äußere Code punktiert wird.

14. System nach einem der vorhergehenden Ansprüche,
    **dadurch gekennzeichnet,**
    **daß** zwischen äußerem und innerem Code Permutationen verwendet werden.

15. System nach Anspruch 14,
    **dadurch gekennzeichnet,**
    **daß** die Permutationen periodisch sind.

16. System nach einem der vorhergehenden Ansprüche,
    **dadurch gekennzeichnet,**
    **daß** die Nutzinformationen und Prüfinformationen in den zeitlich aufeinanderfolgenden Frequenzabschnitten periodisch übertragen werden.

17. System nach Anspruch 16,

**dadurch gekennzeichnet,**
**daß** die Periode durch die Gesamt-Coderate und die Anzahl der pro Frequenzabschnitt übertragenen Informationen bestimmt ist.

18. System nach einem der vorhergehenden Ansprüche,
    **dadurch gekennzeichnet,**
    **daß** die Verteilung der Nutz- und Prüfinformationen auf die zeitlich aufeinanderfolgenden Frequenzabschnitte so gewählt ist, daß der Übertragungskanal keine Fehlerfortpflanzung mehr aufweist.

19. System nach einem der vorhergehenden Ansprüche,
    **dadurch gekennzeichnet,**
    **daß** die Verteilung von Nutz- und Prüfinformationen auf die Frequenzabschnitte so gewählt ist, daß die Verzögerung durch die Codierung minimal ist.

20. System nach einem der vorhergehenden Ansprüche,
    **dadurch gekennzeichnet,**
    **daß** die Codes so gewählt sind, daß die angestrebte maximale Fehlerrate nach der Decodierung eingehalten wird.

21. System nach einem der vorhergehenden Ansprüche,
    **dadurch gekennzeichnet,**
    **daß** bei Änderung der Übertragungseigenschaften des Übertragungskanals die verwendeten Codeschemata entsprechend angepaßt werden.

22. System nach Anspruch 21,
    **dadurch gekennzeichnet,**
    **daß** im Multiplex zur Datenübertragung Zusatzinformationen über den momentan benutzten Code vom Sender zum Empfänger übertragen werden.

23. System nach Anspruch 22,
    **dadurch gekennzeichnet,**
    **daß** die Zusatzinformation jeweils gesendet wird, wenn der Sender die Codeschemata ändert.

24. System nach Anspruch 22 oder 23,
    **dadurch gekennzeichnete**
    **daß** die Zusatzinformation nach einem Woven Code codiert und verteilt auf mehrere Frequenzabschnitte übertragen wird.

25. System nach Anspruch 22 bis 24,
    **dadurch gekennzeichnet,**
    **daß** die Coderate für die Zusatzinformation kleiner gewählt ist als die normale Datenübertragungsrate.

26. System nach einem oder mehreren der vorhergehenden Ansprüche,

**dadurch gekennzeichnet,**
**daß** die codiert übertragenen Daten im Empfänger mittels eines iterativen Turbodecoders decodiert werden.

27. System nach Anspruch 26,
**dadurch gekennzeichnet,**
**daß** der innere und der äußere Code nach dem APP-Algorithmus decodiert wird und dabei die Information über die Terminierung der Codes berücksichtigt wird.

28. System nach Anspruch 26 oder 27,
**dadurch gekennzeichnet,**
**daß** zur Reduktion der Verzögerung der Decodierung eine Sliding-Window-Version des APP-Decoders benutzt wird.

29. System nach einem der Ansprüche 1 bis 28, .
**dadurch gekennzeichnet,**
**daß** die je Frequenzabschnitt zu übertragenden Daten auf mehrere parallele mit unterschiedlichen Frequenzen gesendete Frequenzabschnitte verteilt übertragen werden.

30. System nach Anspruch 29 für einen woven code mit outer warp,
**dadurch gekennzeichnet,**
**daß** die Codierung des inneren Codes über alle parallel . ausgesendete Frequenzabschnitte übertragen wird.

31. System nach Anspruch 29 für einen woven code mit inner warp,
**dadurch gekennzeichnet,**
**daß** die äußere Codierung über alle parallel ausgesendeten Frequenzabschnitte, die jeweils Nutzinformationen beinhalten, übertragen wird.

32. System nach Anspruch 4 für einen woven code mit double warp,
**dadurch gekennzeichnet,**
**daß** die Nutzinformationen sowie die Prüfinformationen des äußeren und inneren Codes auf die parallel ausgesendeten Frequenzabschnitte verteilt übertragen werden.

33. System nach Anspruch 10 für einen woven turbo code,
**dadurch gekennzeichnet,**
**daß** die Nutzinformationen-sowie die Prüfinformationen des äußeren und inneren Codes auf die parallel ausgesendeten Frequenzabschnitte verteilt übertragen werden.

34. System nach einem der vorhergehenden Ansprüche,
**dadurch gekennzeichnet,**
**daß** die Verteilung der einzelnen Daten auf die parallel ausgesendeten Frequenzabschnitte willkürlich erfolgt.

35. System nach Anspruch 34,
**dadurch gekennzeichnet,**
**daß** die Verteilung der einzelnen Daten auf die parallel ausgesendeten Frequenzabschnitte zeitlich geändert wird.

36. System nach einem der vorhergehenden Ansprüche,
**dadurch gekennzeichnet,**
**daß** die gesamten Daten eines Frequenzabschnittes auf mehrere parallel mit unterschiedlichen Frequenzen gesendeten Frequenzabschnitten übertragen werden.

37. System nach einem der vorhergehenden Ansprüche,
**dadurch gekennzeichnet,**
**daß** der Frequenzabstand der parallel ausgesendeten Frequenzabschnitte konstant ist.

38. System nach einem der vorhergehenden Ansprüche,
**dadurch gekennzeichnet,**
**daß** der Frequenzabstand der parallel ausgesendeten Frequenzabschnitte äquidistant ist.

39. System nach einem der vorhergehenden Ansprüche,
**dadurch gekennzeichnet,**
**daß** der Frequenzabstand der parallel ausgesendeten Frequenzabschnitte nach einem vorgegebenen Algorithmus zeitabhängig geändert wird.


**Claims**

1. System for transmitting data by the frequency hopping method, in which the digital data are transmitted in abruptly changing transmission frequency segments, wherein the data in the consecutive frequency segments are encoded according to a woven code that comprises the concatenation of an outer and an inner convolutional code,
**characterized in that**
encoding is performed according to the woven code with outer warp, wherein the user information items are transmitted in one of the frequency segments, the test information items of the outer code are transmitted in another of the frequency segments and the test information items of the inner code, together with the user information items and the test information items of the outer code, are transmitted in all the frequency segments.

**2.** System according to Claim 1,
**characterized in that**
the inner code is terminated.

**3.** System according to Claim 2,
**characterized in that**
the outer code has a greater redundancy.

**4.** System for transmitting data by the frequency hopping method, in which the digital data are transmitted in abruptly changing transmission frequency segments, wherein the data in the consecutive frequency segments are encoded according to a woven code that comprises the concatenation of an outer and an inner convolutional code,
**characterized in that**
encoding is performed according to the woven code with inner warp, wherein the user information items and test information items of the outer code are transmitted together in one of the frequency segments and the test information items of the inner code are transmitted in each case in other frequency segments.

**5.** System according to Claim 4,
**characterized in that**
the outer code is terminated.

**6.** System according to Claim 4 or 5,
**characterized in that**
the inner code has a greater redundancy.

**7.** System for transmitting data by the frequency hopping method, in which the digital data are transmitted in abruptly changing transmission frequency segments, wherein the data in the consecutive frequency segments are encoded according to a woven code that comprises the concatenation of an outer and an inner convolutional code,
**characterized in that**
encoding is performed according to the woven code with double warp and the user information items, test information items of the outer code and the test information items of the inner code are each transmitted in different frequency segments.

**8.** System according to Claim 7,
**characterized in that**
the outer code is terminated.

**9.** System according to Claim 7 or 8,
**characterized in that**
the inner code has a greater redundancy.

**10.** System for transmitting data by the frequency hopping method, in which the digital data are transmitted in abruptly changing transmission frequency segments, wherein the data in the consecutive frequency segments are encoded according to a woven code that comprises the concatenation of an outer and an inner convolutional code,
**characterized in that** encoding is performed according to the woven turbo code, wherein about the same code rate is used in each case for the inner and outer convolutional code and the user information items and also the test information items of the outer and inner codes are each transmitted in separate frequency segments.

**11.** System according to Claim 10,
**characterized in that**
both the outer and the inner code are punctured.

**12.** System according to any of Claims 1 to 11,
**characterized in that**
the inner and/or outer code is terminated.

**13.** System according to any of Claims 1 to 10,
**characterized in that**
the outer code is punctured.

**14.** System according to any of the preceding claims,
**characterized in that**
permutations are used between outer and inner code.

**15.** System according to Claim 14,
**characterized in that**
the permutations are cyclic.

**16.** System according to any of the preceding claims,
**characterized in that**
the user information items and test information items in the temporally consecutive frequency segments are transmitted cyclically.

**17.** System according to Claim 16,
**characterized in that**
the cycle is determined by the total code rate and the number of information items transmitted per frequency segment.

**18.** System according to any of the preceding claims,
**characterized in that**
the chosen distribution of the user information items and test information items in the temporally consecutive frequency segments is chosen in such a way that the transmission channel no longer has any error propagation.

**19.** System according to any of the preceding claims,
**characterized in that**
the chosen distribution of user information items and test information items over the frequency segments is chosen in such a way that the delay due to the encoding is minimum.

**20.** System according to any of the preceding claims, **characterized in that**
the codes are chosen in such a way that the desired maximum error rate is maintained after decoding.

**21.** System according to any of the preceding claims, **characterized in that**,
if the transmission properties of the transmission channel are changed, the code schemes used are adapted accordingly.

**22.** System according to Claim 21, **characterized in that**
additional information items about the currently used code are transmitted from the transmitter to the receiver multiplexed with the data transmission.

**23.** System according to Claim 22, **characterized in that**
the additional information is transmitted whenever the transmitter changes the code schemes.

**24.** System according to Claim 22 or 23, **characterized in that**
the additional information is encoded according to a woven code and is transmitted distributed over a plurality of frequency segments.

**25.** System according to Claims 22 to 24, **characterized in that**
the chosen code rate for the additional information is less than the normal data transmission rate.

**26.** System according to one or more of the preceding claims, **characterized in that**
the encoded transmission data are decoded in the receiver by means of an iterative turbo decoder.

**27.** System according to Claim 26, **characterized in that**
the inner and the outer codes are decoded according to the APP algorithm and, during decoding, the information about the termination of the codes is taken into account.

**28.** System according to Claim 26 or 27, **characterized in that**,
to reduce the delay in decoding, a sliding window version of the APP decoder is used.

**29.** System according to any of Claims 1 to 28, **characterized in that**
the data to be transmitted per frequency segment are transmitted distributed over a plurality of parallel frequency segments transmitted at difference frequencies.

**30.** System according to Claim 29 for a woven code with outer warp, **characterized in that**
the encoding of the inner code is transmitted over all the frequency segments emitted in parallel.

**31.** System according to Claim 29 for a woven code with inner warp, **characterized in that**
the outer coding is transmitted over all the frequency segments emitted in parallel that contain user information items in each case.

**32.** System according to Claim 4 for a woven code with double warp, **characterized in that**
the user information items and also the test information items of the outer and inner codes are transmitted distributed over the frequency segments emitted in parallel.

**33.** System according to Claim 10 for a woven turbo code, **characterized in that**
the user information items and also the test information items of the outer and inner codes are transmitted distributed over the frequency segments emitted in parallel.

**34.** System according to any of the preceding claims, **characterized in that**
the individual data are arbitrarily distributed over the frequency segments emitted in parallel.

**35.** System according to Claim 34, **characterized in that**
the distribution of the individual data over the frequency segments emitted in parallel is changed temporally.

**36.** System according to any of the preceding claims, **characterized in that**
the entire data of a frequency segment is transmitted in a plurality of frequency segments transmitted in parallel at different frequencies.

**37.** System according to any of the preceding claims, **characterized in that**
the frequency spacing of the frequency segments emitted in parallel is constant.

**38.** System according to any of the preceding claims, **characterized in that**
the frequency spacing of the frequency segments emitted in parallel is equidistant.

**39.** System according to any of the preceding claims, **characterized in that**

the frequency spacing of the frequency segments emitted in parallel is changed as a function of time according to a predetermined algorithm.

## Revendications

1. Système de transmission de données selon le procédé à saut de fréquence, dans lequel les données numériques sont transmises en segments de fréquence d'émission, alternant par des sauts, où les données se trouvant dans les segments de fréquence successifs sont codées selon un code Woven formé d'une concaténation d'un code à déploiement extérieur et d'un autre intérieur, **caractérisé en ce que** l'on code selon le code Woven avec Outer Warp, sachant que les informations utiles dans l'un des segments de fréquence, les informations de contrôle du code extérieur sur l'autre des segments de fréquence, et les informations de contrôle du code intérieur sont transmises, conjointement avec les informations utiles et les informations de contrôle du code extérieur, sur l'ensemble des codes du segment de fréquence.

2. Système selon la revendication 1, **caractérisé en ce que** le code intérieur est l'objet d'une délimitation.

3. Système selon la revendication 2, **caractérisé en ce que** le code extérieur présente une plus grande redondance.

4. Système de transmission de données selon le procédé à saut de fréquence, dans lequel les données numériques sont transmises par segments de saut de fréquence alternant par sauts; où les données se trouvant dans les segments de fréquence successifs sont codées selon un code Woven formé d'une concaténation d'un code à déploiement extérieur et d'un autre intérieur, **caractérisé en ce qu'**on code le code Woven avec Inner Warp, sachant que les informations utiles et les informations de contrôle du code extérieur, conjointement, sont transmises dans l'un des segments de fréquence, et que les informations de contrôle du code intérieur sont transmises chaque fois dans les autres segments de fréquence.

5. Système selon la revendication 4, **caractérisé en ce que** le code extérieur est l'objet d'une délimitation.

6. Système selon la revendication 4 ou 5, **caractérisé en ce que** le code intérieur présente une plus grande redondance.

7. Système de transmission de données selon le procédé à saut de fréquence, dans lequel les données numériques sont transmises en segments de fréquence d'émission, alternant par des sauts, où les données se trouvant dans les segments de fréquence successifs sont codées selon un code Woven formé d'une concaténation d'un code à déploiement extérieur et d'un autre intérieur, **caractérisé en ce que** on code selon le code Woven avec Double Warp, et les informations utiles, les informations de contrôle du code extérieur et les informations de contrôle du code intérieur sont chaque fois transmises dans des segments de fréquence différents.

8. Système selon la revendication 7, caractérisé en ce le code extérieur est soumis à délimitations.

9. Système selon la revendication 7 ou 8, caractérisé en ce le code intérieur présente une plus grande redondance.

10. Système de transmission de données selon le procédé à saut de fréquence, dans lequel les données numériques sont transmises en segments de fréquence d'émission, alternant par des sauts, uù les données se trouvant dans les segments de fréquence successifs sont codées selon un code Woven, formé d'une concaténation d'un code à déploiement extérieur et d'un autre intérieur, **caractérisé en ce que** l'on code suivant le Turbocode Woven, sachant que, pour le code à déploiement intérieur et celui extérieur, on utilise chaque fois à peu près le même taux de codage, et que les informations utiles, ainsi que les informations de contrôle du code extérieur et du code intérieur sont chacune transmises en des segments de fréquence séparés.

11. Système selon la revendication 10, caractérisé en ce tant le code extérieur qu'également le code intérieur sont ponctués.

12. Système selon l'une des revendications 1 à 11, **caractérisé en ce que** le code intérieur et/ou le code extérieur sont soumis à délimitations.

13. Système selon l'une des revendications 1 à 10, **caractérisé en ce que** le code extérieur est ponctué.

14. Système selon l'une des revendications précédentes, **caractérisé en ce que** l'on utilise des permutations entre le code extérieur et le code intérieur.

15. Système selon la revendication 14, **caractérisé en ce que** les permutations sont périodiques

16. Système selon l'une des revendications précédentes, **caractérisé en ce que** les informations utiles et les informations de contrôle sont transmises périodiquement dans les segments de fréquence se succédant temporellement.

17. Système selon la revendication 16, **caractérisé en ce que** la période est déterminée par le taux de codes global et le nombre des informations transmises par segment de fréquence.

18. Système selon l'une des revendications précédentes, **caractérisé en ce que** la distribution des informations utiles et de contrôle sur les segments de fréquence se succédant temporellement est choisie de manière que le canal de transmission ne présente aucune propagation d'erreur.

19. Système selon l'une des revendications précédentes, **caractérisé en ce que** la distribution des informations utiles et de contrôle sur les segments de fréquence est choisie telle que le retard imputable au codage soit minimal.

20. Système selon l'une des revendications précédentes, **caractérisé en ce que** les codes sont choisis de manière que le taux d'erreur maximal visé après décodage soit respecté.

21. Système selon l'une des revendications précédentes, **caractérisé en ce que**, en cas de modification des propriétés de transmission du canal de transmission, les schémas de codage utilisés sont l'objet d'une adaptation correspondante.

22. Système selon la revendication 21, **caractérisé en ce qu'**en multiplex par rapport à la transmission de données des informations additionnelles concernant le code utilisé momentanément sont transmises de l'émetteur au récepteur.

23. Système selon la revendication 22, **caractérisé en ce que** l'information additionnelle est chaque fois envoyée lorsque l'émetteur modifie les schémas de codage.

24. Système selon la revendication 22 ou 23, **caractérisé en ce que** l'information additionnelle est codée selon un code Woven et transmise, de façon répartie sur plusieurs segments de fréquence.

25. Système selon les revendications 22 à 24, **caractérisé en ce que** le taux d'erreur de l'information additionnelle est choisi inférieur au taux de transmission de données normal.

26. Système selon l'une ou plusieurs des revendications précédentes, **caractérisé en ce que** les données transmises de façon codée sont décodées dans le récepteur, à l'aide d'un turbo décodeur itératif.

27. Système selon la revendication 26, **caractérisé en ce que** le code intérieur et le code extérieur sont décodés selon l'algorithme APP, et l'information étant alors prise en considération par le biais de la délimitation du code.

28. Système selon la revendication 26 ou 27, **caractérisé en ce qu'**une version Sliding-Window du décodeur APP est utilisée afin de réduire le retard du décodage.

29. Système selon l'une des revendications 27 à 28, **caractérisé en ce que** les données à transmettre à chaque segment de fréquence sont transmises de façon répartie sur une pluralité de segments de fréquence, émis parallèlement avec des fréquences différentes.

30. Système selon la revendication 29, pour un code Woven à Outer Warp,
   **caractérisé en ce que**
   le codage du code intérieur est transmis sur tous les segments de fréquence émis parallèlement.

31. Système selon la revendication 29, pour un code Woven à Inner Warp,
   **caractérisé en ce que**
   le codage extérieur est transmis sur tous les segments de fréquence émis parallèlement, contenant chacun des informations utiles.

32. Système selon la revendication 4, pour un code Woven à Double Warp,
   **caractérisé en ce que**
   les informations utiles ainsi que les informations de contrôle du code extérieur et du code intérieur sont transmises de façon répartie sur les segments de fréquence émis parallèlement.

33. Système selon la revendication 10, pour un turbo code Woven
   **caractérisé en ce que**
   les informations utiles ainsi que les informations de contrôle du code extérieur et du code extérieur sont transmises de façon répartie sur les segments de fréquence émis parallèlement.

34. Système selon l'une des revendications précédentes, **caractérisé en ce que** la répartition des données individuelles sur les segments de fréquence émis parallèlement se fait arbitrairement.

35. Système selon la revendication 34, **caractérisé en ce que** la distribution des données individuelles sur les segments de fréquence émis parallèlement est modifiée temporellement.

36. Système selon l'une des revendications précédentes, **caractérisé en ce que** l'ensemble des données d'un segment de fréquence est transmis sur plusieurs segments de fréquence émis parallèlement, à des fréquences différentes.

37. Système selon l'une des revendications précédentes, **caractérisé en ce que** l'espacement entre fréquences des segments de fréquence émis parallèlement est constant.

38. Système selon l'une des revendications précédentes, **caractérisé en ce que** l'espacement entre fréquences des segments de fréquence émis parallèlement est équidistant.

39. Système selon l'une des revendications précédentes, **caractérisé en ce que** l'espacement entre fréquences des segments de fréquence émis parallèlement est modifié en fonction du temps, selon un algorithme prédéterminé.

Codierung in Zeilenrichtung

Codierung in Spaltenrichtung

$f_1$  $f_2$  $f_3$  $f_4$  $f_2$  $f_1$  $f_{..}$  $..$  $f_x$

## Fig. 1

Äußerer
Coder

Innerer
Coder

## Fig. 2

L

Fig. 3

G

G

G

G

Fig. 4

Fig. 5

Fig. 6

Fig. 7

Fig. 8

Vor der Codierung

Nach der äußeren Codierung

Nach der inneren Codierung

Fig. 9

Vor der Codierung

Nach der äußeren Codierung

Nach der inneren Codierung

Fig. 10

Vor der Codierung

Nach der äußeren Codierung

Nach der inneren Codierung

Fig. 11

Vor der Codierung

Nach der äußeren Codierung

Nach der inneren Codierung

Fig. 12

Fig. 13